# EUROPÄISCHE PATENTSCHRIFT

(11) **EP 0 578 958 B1**
(45) Veröffentlichungstag und Bekanntmachung des Hinweises auf die Patenterteilung: **13.11.1996**
(21) Anmeldenummer: 93108915.5
(22) Anmeldetag: 03.06.1993
(51) Int. Cl.: G05F 1/573, H02H 3/093

(54) **Überlastungsschutzschaltung**
Overload protection circuit
Circuit de protection contre la sur intensité

(30) Priorität: 16.07.1992 DE 4223339; 16.07.1992 DE 4223338
(43) Veröffentlichungstag der Anmeldung: 19.01.1994
(73) Patentinhaber: ROBERT BOSCH GMBH, 70442 Stuttgart (DE)
(72) Erfinder: Scholdei, Henning, Dipl.-Ing., W-7150 Backnang (DE)

(56) Entgegenhaltungen:
- EP-A- 0 252 541
- EP-A- 0 373 694
- WO-A-80/02477
- DE-A- 3 116 846
- DE-A- 4 012 356
- FR-A- 2 618 276
- GB-A- 2 141 889

## Beschreibung

Die Erfindung geht aus von einer Überlastungsschutzschaltung gemäß dem Oberbegriff des Patentanspruchs 1. Eine solche Überlastungsschutzschaltung ist bekannt aus der FR 2 618 276 A1.

Aus der DE 40 12 356 A1 ist es bekannt, die Verlustleistung oder eine der Verlustleistung entsprechende Größe eines Schalttransistors zu ermitteln und davon abhängig den Basisstrom zu variieren.

Bei Längsreglern wird üblicherweise zur Begrenzung des Stromes über das Stellglied eine zum Strom proportionale Spannung ermittelt und in Abhängigkeit davon das Stellglied gesteuert. Aus Tietze/Schenk, Halbleiterschaltungstechnik, 2. Auflage 1971, Seiten 338 und 339 ist es bekannt, zur Verhinderung der Überlastung des Stellgliedes im Kurzschlußfall den Strom auf einen Bruchteil des Maiximalstroms herabzusetzen.

Bei der FR 2 618 276 A1 werden zur Begrenzung der Verlustleistung im Stellglied Widerstände zum Stellglied parallel geschaltet. Diese Zuschaltung der Widerstände erfolgt über Schalter, die von einem Rampengenerator gesteuert werden. Als Triggersignal für diesen Rampengenerator dient die gleichgerichtete Eingangsspannung.

Aus der WO 80/02477 A1 ist eine Schutzschaltung für Verstärkerstufen bekannt. Es wird dort die mittlere Leistung eines Eingangssignales gemessen. Für die Messung der mittleren Leistung ist eine Gleichrichterschaltung mit einem RC-Glied als Integrator vorgesehen. Die Werte für dieses RC-Glied werden in Abhängigkeit des Temperaturganges des Verstärkers bestimmt.

In der nicht vorveröffentlichten Druckschrift DE-A-41 38 989.1 wurde vorgeschlagen in Abhängigkeit des Spannungsabfalls am Stellglied eine Stromquelle zu steuern und den von dieser Stromquelle gelieferten Strom zu integrieren. Über einen Komparator wird dort ein Signal proportional zum integrierten Strom mit einem Referenzsignal verglichen, um ein Abschaltsignal für das Stellglied zu erzeugen.

In der ebenfalls nicht vorveröffentlichten Druckschrift DE A 41 28 679.0 ist eine Schutzschaltung vorgesehen, die den Längsregler bei Erreichen einer vorgegebenen zulässigen Verlustleistung ebenfalls abschaltet. Der Abschaltzeitpunkt ist dort starr vorgegeben und auf den "worst case" dimensioniert. Aufgabe vorliegender Erfindung ist es die Überlastungsschutzschaltung eingangs genannter Art so weiterzubilden, daß die Abschaltung des Stellgliedes anhand der tatsächlichen aufgenommenen Verlustleistung erfolgt.

Diese Aufgabe wird durch die Maßnahmen des Anspruchs 1 gelöst. Die weiteren Ansprüche zeigen vorteilhafte Weiterbildungen auf.

Die Erfindung beruht auf der Erkenntnis, daß im Regelbetrieb der Strom über dem Stellglied konstant ist und damit die Verlustleistung proportional ist zum Spannungsabfall über dem Stellglied. Wenn dieser Spannungsabfall, im Falle der Ausbildung des Stellgliedes als Feldeffekttransistor die Drain-Source Spannung, einem Integrator zugeführt wird, dessen Zeitkonstante auf die thermische Zeitkonstante des Stellgliedes abgestimmt ist, ist die Spannung am Integrator ein Maß für die Verlustenergie bzw. die Temperatur des Stellgliedes (Sperrschichttemperatur). Die Integratorspannung kann dann mit einem Referenzwert verglichen werden und bei Überschreiten dieses Referenzwertes als Abschaltkriterium für das Stellglied dienen.
Um die Verlustleistung gering zu halten, kann das Stellglied gemäß der Ausbildung nach Anspruch 2 außerhalb seines Regelbetriebes niederohmig überbrückt werden. Die Steuerung dieser Überbrückungsfunktion kann vorteilhaft in Abhängigkeit des Ausgangssignals des Komparators erfolgen.

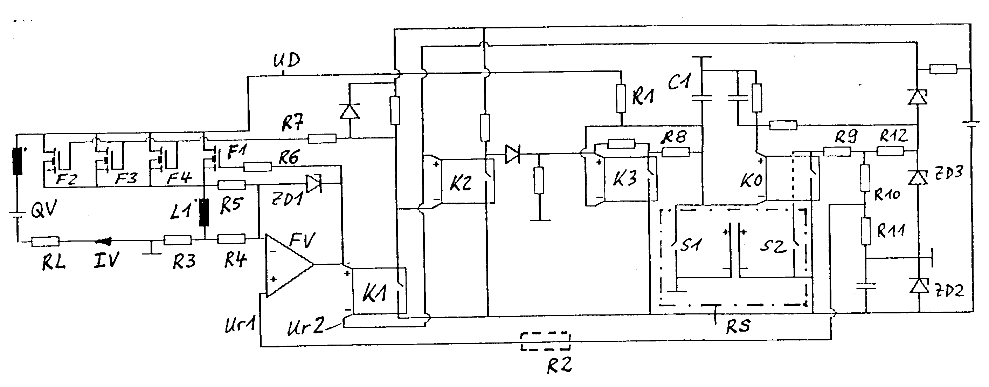

Anhand der Zeichnung, die ein Prinzipschaltbild einer Überlastungsschutzschaltung für einen Regler zeigt, wird im Ausführungsbeispiel der Erfindung nun näher erläutert.

In der Figur ist eine Versorgungsgleichspannungsquelle QV dargestellt über die ein Verbraucher RL stromversorgt wird. In Serie zur Versorgungsgleichspannungsquelle QV ist ein Stellglied in Form eines Feldeffekttransistors F1 angeordnet und eine Induktivität L1. Die Induktivität L1 begrenzt die Stromänderungsgeschwindigkeit. Das Stellglied F1 dient zur Regelung des Verbraucherstroms auf einen möglichst konstanten Wert und zur Unterbrechung des Verbraucherstromkreises bei Überlastung, z.B. bei Kurzschluß des Verbrauchers. Zwischen der Induktivität L1 und dem Verbraucher RL befindet sich ein Strommeßwiderstand R3. Die über den Strommeßwiderstand R3 erfaßte zum Laststrom IV proportionale Spannung wird dem invertierenden Eingang des Fehlerverstärkers FV, der als Operationsverstärker aufgebaut ist, über den Widerstand R4 zugeführt. Sobald die Spannung am invertierenden Eingang des Operationsverstärkers FV so groß wird wie die Spannung Ur1 am Referenzeingang - nichtinvertierender Eingang - liegt Regelbetrieb vor und die Spannung am Gate des Feldeffekttransistors F1 wird so weit zurückgenommen, daß der Verbraucherstrom IV nicht weiter ansteigt.

Am Abgreifpunkt zwischen Stellglied F1 und Induktivität L1 ist ein Widerstand R5 angeschlossen, der zum invertierenden Eingang des Operationsverstärkers FV führt. Durch diese zusätzliche Signaleinkopplung am Operationsverstärker FV können D-Anteile des Verbraucherstromes IV, d.h. schnelle Stromänderungen, unverzüglich durch den Operationsverstärker FV ausgewertet werden.

Der Operationsverstärker FV ist nur über eine Zenerdiode ZD1 gegengekoppelt. Sein Ausgang ist über den Widerstand R6, der normalerweise nicht notwendig ist und nur zur Begrenzung von zu hohen Strömen vorgesehen ist, mit dem Steuereingang des Stellgliedes , d.h. mit dem Gate des Feldeffekttransistors F1 verbunden. Damit wird die Stromauswerteeinrichtung zu einem Stromregler ergänzt. Durch die Gegenkupplung nur mittels der Zenerdiode ZD1 entsteht ein sehr schneller Regler mit Integrationsverhalten, da die Zenerdiode ZD1 den Ausgang des Operationsverstärkers FV auf einer Spannung von beispielsweise 10 V und damit außerhalb der Sättigung hält. Somit wirkt nur die parasitäre Kapazität.

Wenn die Spannung am invertierenden Eingang des Operationsverstärkers FV kleiner ist als die Spannung am nichtinvertierenden Eingang, ist die Ausgangsspannung des Operationsverstärkers FV auf H-Potential, z.B. 10 V. In diesem Betriebsfall wird das Stellglied F1 niederohmig überbrückt und kann dadurch keine unnötige Verlustleistung erzeugen. Zu diesem Zweck sind die drei Feldeffekttransistoren F2, F3, F4, vorgesehen, die dann parallel zum Feldeffekttransistor F1 geschaltet werden; d.h. durch die Parallelschaltung dreier weiterer Halbleiterbahnwiderstände zum Halbleiterbahnwiderstand des Feldeffekttransistors F1 verringert sich der Gesamtwiderstand im Lastkreis und damit die auftretenden Verluste. Der Feldeffekttransistor F1 bleibt zwar angesteuert, aber er wird durch die Überbrückung in einem Betriebszustand unwirksam geschaltet in dem er sowieso nicht gebraucht wird und nur unnötige Verlustleistung erzeugen würde. Zur Aktivierung der Feldeffekttransistoren F2, F3, F4 und damit zur Realisierung der Überbrückungsfunktion wird die Ausgangsspannung des Operationsverstärkers FV dem Komparator K1 zugeführt, der diese Spannung mit der Referenzspannung Ur2 vergleicht, die um den Wert einer Zenerdiodenspannung höher ist als die Referenzspannung Ur1, die dem Operationsverstärker FV zugeführt ist. Der Ausgang des Komparators K1 führt über den Widerstand R7 zu den Gates der Feldeffekttransistoren F2, F3, F4 und steuert diese für diesen Betriebszustand durch. Wenn nun am Operationsverstärker FV an seinem invertierenden Eingang eine höhere Spannung erscheint als die Spannung Ur1, z.B. durch einen plötzlichen Stromanstieg des Verbraucherstromes IV, wird der Ausgangstransistor des Komparators K1, in der Figur durch einen Schalter symbolisiert, voll durchgeschaltet und erniedrigt damit sofort die Gatespannungen an den Feldeffekttransistoren F2, F3, F4, wodurch die niederohmige Überbrückung des Stellgliedes F1 aufgehoben wird und der Regler wieder in seinen Regelbetrieb - Konstantregelung des Verbraucherstromes IV - übergeht. Die Komparatoren K2, K3 und K0 bilden zusammen mit dem RC-Glied R1, C1, das die Drainspannung UD der Feldeffekttransistoren F1, F2, F3 und F4 auswertet, die erfindungsgemäße Überlastungsschutzschaltung.
Das RC-Glied bestehend aus dem Ladewiderstand R1, der zwischen Drain der Feldeffekttransistoren F1, F2, F3 und F4 und dem invertierenden Eingang des Komparators KO liegt, und dem Kondensator C1, der zwischen Massepotential und ebenfalls dem invertierenden Eingang des Komparators KO liegt, bildet einen Integrator für die Drainspannung UD der Feldeffekttransistoren F1, F2, F2 und F4. Da der Verbraucherstrom IV im Regelbetrieb des Reglers auf einen konstanten Wert geregelt wird, ist die Verlustleistung damit proportional zur Drainspannung der Feldeffekttransistoren F1, F2, F3 und F4. Die Zeitkonstante des RC-Gliedes R1, C1 ist erfindungsgemäß auf die thermische Zeitkonstante des Feldeffekttransistors F1 abgestimmt (gleiches τ). Durch diese Dimensionierung entspricht die Höhe der Spannung am Kondensator C1 jeweils der Sperrschichttemperatur des Feldeffekttransistors F1, wodurch eine hinsichtlich bisheriger Lösungen genauere Auswertung der vom Stellglied F1 aufgenommenen Verlustenergie möglich ist und das Stellglied F1 sicher vor Überlastung geschützt werden kann.

Die beiden Komparatoren K2 und K3 halten den Kondensator C1 im Entladezustand für den Fall, daß das Stellglied F1 nicht im Regelbetrieb arbeitet (verbraucherstromproportionale Spannung am Operationsverstärker FV kleiner als das Bezugssignal Ur1) und das Stellglied F1 niederohmig durch die Feldeffekttransistoren F2, F3 und F4 überbrückt ist. Hierzu erfaßt der Komparator K2 an seinem invertierenden Eingang die Gatespannung der Feldeffekttransistoren F2, F3 und F4. Der ihm nachgeschalteten Komparator K3 arbeitet als einfacher und langsamer Schaltregler. Der Kondensator C1 wird durch den Komparator K3 entladen über den Widerstand R8 und den symbolisch als Schalter dargestellten Transistor am Ausgang des Komparators K3, wenn die Ausgangsspannung des Komparators K2 positiv ist und die Feldeffekttransistoren F2, F3 und F4 eingeschaltet sind. Die Entladung des Kondensators C1 in diesem Betriebszustand ist notwendig, da die Drain-Source Spannung der Feldeffekttransistoren F1, F2, F3 und F4 für diesen Betriebszustand nicht proportional zur Verlustleistung ist, da sich der Verbraucherstrom auf die Bahnwiderstände der vier Feldeffekttransistoren F1, F2, F3 und F4 aufteilt.

Zur Dimensionierung des RC-Gliedes R1, C1 zur Simulation der Sperrschichtkapazität müssen insbesondere für den Einsatz in Satelliten zwei Fälle betrachtet werden: während des Dauerbetriebs muß die Sperrschichttemperatur des Feldeffekttransistors F1 unter 115° C bleiben. Nur kurzzeitig und nichtperiodisch ist eine Temperatur von 135° C zulässig. Die Umgebungstemperatur für den "worst case" beträgt 65° C. Demnach ist für den Dauerbetrieb der zulässige Temperaturgradient 50 K und für den Kurzzeitbetrieb 70 K. Mit einem angenommenen Wärmewiderstand von 10 K/W und einem Nennstrom von 15 A erhält man eine Begrenzungsschwelle von 0,33 V. Im Falle eines Kurzschlusses mit 42 V (630 W) ergaben Messungen, daß der Temperaturgradient von 70 K nach 4 msec erreicht wird. Aus diesem Grunde wird der Ladewiderstand R1 für eine Begrenzungszeit von 3 msec bei 42 V Versorgungsspannung bemessen. In einer erprobten Schaltung wurde für den Ladewiderstand R1 ein 1,5 Megohm Widerstand und ein Kondensator C1 von 270 nF verwendet. Wenn die Begrenzungsschwelle am Kondensator C1 erreicht ist, schaltet der Transistor im Ausgangskreis des Komparators KO durch und schaltet damit den Widerstand R9 parallel zum Spannungsteiler R10, R11, R12, ZD2, ZD3, an dem das Bezugssignal Ur1 abgegriffen wird. Das Bezugssignal - Referenzspannung Ur1 - für den Operationsverstärker FV wird dadurch abgesenkt, was zur Folge hat, daß der Operationsverstärker FV den Feldeffekttransistor F1 abschaltet. Die Drain-Source-Spannung der Feldeffekttransistoren F1, F2, F3 und F4 bleibt hoch und die Überbrückung des Stellgliedes F1 durch die Feldeffekttransistoren F2, F3 und F4 ist außer Funktion.

Wenn der Verbraucherstrom IV unter den Schwellwert zur Aktivierung des Reglers sinkt bevor die Spannung am Kondensator C1 die Begrenzungsschwelle erreicht, werden die Feldeffekttransistoren F2, F3 und F4 angesteuert zur Überbrückung des Stellgliedes F1. Der Kondensator C1 wird über den Widerstand R8 von beispielsweise 2 Megohm langsam entladen, so daß im Falle einer erneuten kurz danach auftretenden Überlastung, zu einem Zeitpunkt, zu dem sich der Feldeffekttransistor F1 noch nicht vollständig wieder abgekühlt hat, der Kondensator C1 mit der Spannungsintegration von einem höheren Startwert aus beginnt, was zur Folge hat, daß die Begrenzungsschwelle und damit der Abschaltzeitpunkt für das Stellglied F1 früher erreicht ist.

Über eine Rücksetzeinrichtung RS, die an den Komparator KO angeschlossen ist, kann der Regler wieder in Bereitschaft gebracht werden. Die Rücksetzeinrichtung RS weist die beiden synchronen Schalter S1 und S2 auf. Über den Schalter S1 kann der Kondensator C1 nach Masse geschaltet werden und damit schnell entladen werden. Über den Schalter S2 läßt sich während des Rücksetzens das Bezugssignal Ur1 niedrig und damit das Stellglied gesperrt halten. Die Aktivierung der Rücksetzeinrichtung kann beispielsweise über das Telekommand-Interface eines Satelliten erfolgen.

Um den Verbraucherstrom IV möglichst verlustarm und ohne Zusatzaufwand zu erfassen, ist der Stromsensor - Strommeßwiderstand R3 - als Leiterbahn oder als Teil einer Leiterbahn auf einem Schaltungsträger, z.B. einer gedruckten Schaltung, ausgebildet. Meßverfälschungen durch Temperatureffekte bei der Stromerfassung können dadurch kompensiert werden, daß die Zuleitung des Bezugssignals Ur1 zum Operationsverstärker FV über eine ebensolche Leiterbahn oder ein Teil davon erfolgt, die mit der Leiterbahn des Stromsensors R3 in thermischem Kontakt steht. In der Figur ist diese Leiterbahn durch den gestrichelten Widerstand R2 symbolisiert. Die Leiterbahnen der Widerstände R3 und R2 sind vorzugsweise aus gleichem Material, z.B. Kupfer, besitzen gleiche geometrische Abmessungen (gleiche Abstrahlflächen) und verlaufen eng benachbart, damit sie in gutem thermischen Kontakt zueinander sind.

## Patentansprüche

1. Überlastungsschutzschaltung für das Stellglied (F1) eines Reglers unter Verwendung eines Komparators (KO), welcher eine elektrische Größe (UD) am Stellglied (F1) mit einem Referenzsignal (Ur1) vergleicht und bei Erreichen einer vorgegebenen Verlustenergie das Stellglied (F1) abschaltet, wobei dem Komparator (KO) ein Integrator (R1, C1) vorgeschaltet ist, dadurch gekennzeichnet, daß der Integrator (R1, C1) so beschaltet ist, daß er die Spannung am Stellglied aufintegriert, und daß er bezüglich seiner Zeitkonstante auf die thermische Zeitkonstante des Stellgliedes (F1) derart abgestimmt ist, daß die Spannung am Integrator (R1, C1) ein Maß für die Verlustenergie bzw. die Temperatur des Stellgliedes (F1) ist.

2. Überlastungsschutzschaltung nach Anspruch 1, dadurch gekennzeichnet, daß Mittel (F2, F3, F4) vorgesehen sind, die geeignet sind, das Stellglied (F1) des Reglers insbesondere außerhalb seines Regelbetriebs im voll durchgeschalteten Zustand niederohmig zu überbrücken.

3. Überlastungsschutzschaltung nach Anspruch 1 oder 2, dadurch gekennzeichnet, daß der Integrator aus einem RC-Glied (R1, C1) besteht und daß eine Auswerteeinrichtung (K1, K2) vorgesehen ist zur Feststellung, ob der Regler außerhalb seines Regelbetriebs ist, und zur Entladung des Kondensators (C1) des RC-Gliedes (R1, C1) für diesen Betriebszustand.

4. Überlastungsschutzschaltung nach einem der Ansprüche 1 bis 3, dadurch gekennzeichnet, daß das Stellglied (F1) als Feldeffekttransistor ausgebildet ist und daß die thermische Zeitkonstante des Stellgliedes (F1) so auf die Zeitkonstante des Integrators/RC-Gliedes (R1, C1) abgestimmt ist, daß die Spannung am Integrationskondensator (C1) ein Maß für die Sperrschichttemperatur des Feldeffekttransistors (F1) darstellt.

5. Überlastungsschutzschaltung nach einem der Ansprüche 1 bis 4, gekennzeichnet durch eine Rücksetzeinrichtung (RS) zur schnellen Entladung des Integrationskondensators (C1) und gegebenenfalls zur Verhinderung eines ungeschützten Einschaltens des Stellgliedes (F1).

6. Überlastungsschutzschaltung nach einem der Ansprüche 1 bis 5, dadurch gekennzeichnet, daß die Mittel zur niederohmigen Überbrückung des Stellgliedes (F1) aus einem oder mehreren parallel geschalteten Feldeffekttransistor/en (F2, F3, F4) besteht/bestehen, der/die über die Auswerteeinrichtung (K1, K2) abschaltbar ist/sind, wenn der Strom über das Stellglied (F1) einen vorgegebenen Wert überschreitet.

7. Überlastungsschutzschaltung nach einem der Ansprüche 1 bis 6, dadurch gekennzeichnet, daß zur Steuerung des Stellgliedes (F1) ein Fehlerverstärker (FV) vorgesehen ist, der ein zum Strom über das Stellglied (F1) proportionales Signal mit einem Bezugssignal (Ur1) vergleicht, welches in Abhängigkeit des Ausgangssignals des Komparators (KO) veränderbar ist.

8. Überlastungsschutzschaltung nach Anspruch 7, dadurch gekennzeichnet, daß der Fehlerverstärker (FV) nur über eine Zenerdiode (ZD1) gegengekoppelt ist.

9. Überlastungsschutzschaltung nach Anspruch 7 oder 8, dadurch gekennzeichnet, daß dem Fehlerverstärker (FV) zur Auswertung des Stromes über das Stellglied (F1) ein Stromsensor (R3) zugeordnet ist, der aus einer ersten Leiterbahn oder einem Teil davon besteht, und daß das Bezugssignal (Ur1) über eine weitere Leiterbahn (R2) oder einen Teil davon geführt ist, die mit der ersten Leiterbahn (R3) in thermischem Kontakt ist.

10. Überlastungsschutzschaltung nach Anspruch 9, dadurch gekennzeichnet, daß die erste und die weitere Leiterbahn (R3, R2) oder ihre entsprechenden Teile Bestandteile einer gedruckten Schaltung sind und daß die Leiterbahnen (R3, R2) bzw. ihre Teile benachbart auf dem Schaltungsträger angeordnet sind.

11. Überlastungsschutzschaltung nach einem der Ansprüche 7 bis 10, dadurch gekennzeichnet, daß zwischen dem Stellglied (F1) und dem Stromsensor (R3) zur Auswertung des Stromes über das Stellglied (F1) eine Induktivität (L1) vorgesehen ist und daß dem Fehlerverstärker (FV) zusätzlich ein Signal zugeführt ist, welches zwischen dem Stellglied (F1) und der Induktivität (L1) abgreifbar ist.

## Claims

1. Overload protection circuit for the control element (F1) of a regulator using a comparator (KO) which compares an electrical variable (UD) at the control element (F1) with a reference signal (Ur1) and switches the control element (F1) off on reaching a predetermined energy loss, an integrator (R1, C1) being connected upstream of the comparator (KO), characterized in that the integrator (R1, C1) is connected such that it integrates the voltage on the control element, and in that its time constant is matched to the thermal time constant of the control element (F1) in such a manner that the voltage on the integrator (R1, C1) is a measure of the energy loss or the temperature of the control element (F1).

2. Overload protection circuit according to Claim 1, characterized in that means (F2, F3, F4) are provided which are suitable for bridging the control element (F1) of the regulator in a low-impedance manner in particular outside its regulating operation, in the fully switched-through state.

3. Overload protection circuit according to Claim 1 or 2, characterized in that the integrator comprises an RC element (R1, C1), and in that an evaluation device (K1, K2) is provided in order to determine whether the regulator is outside its regulating operation, and in order to discharge the capacitor (C1) of the RC element (R1, C1) for this operating state.

4. Overload protection circuit according to one of Claims 1 to 3, characterized in that the control element (F1) is configured as a field-effect transistor, and in that the thermal time constant of the control element (F1) is matched to the time constant of the integrator/RC element (R1, C1) such that the voltage on the integration capacitor (C1) represents a measure of the depletion layer temperature of the field-effect transistor (F1).

5. Overload protection circuit according to one of Claims 1 to 4, characterized by a reset device (RS) for rapid discharging of the integration capacitor (C1) and, if required, for preventing the control element (F1) switching on in an unprotected manner.

6. Overload protection circuit according to one of Claims 1 to 5, characterized in that the means for low-impedance bridging of the control element (F1) comprises/comprise one or more parallel-connected field-effect transistors (F2, F3, F4) which can be switched off via the evaluation device (K1, K2) if the current via the control element (F1) exceeds a predetermined value.

7. Overload protection circuit according to one of Claims 1 to 6, characterized in that an error amplifier (FV) is provided for controlling the control element (F1), which error amplifier (FV) compares a signal which is proportional to the current via the control element (F1) with a reference signal (Ur1) which can be varied as a function of the output signal of the comparator (KO).

8. Overload protection circuit according to Claim 7, characterized in that the error amplifier (FV) has negative feedback only via a Zener diode (ZD1).

9. Overload protection circuit according to Claim 7 or 8, characterized in that the error amplifier (FV) is assigned a current sensor (R3) in order to evaluate the current via the control element (F1), which current sensor (R3) comprises a first conductor track or a part thereof, and in that the reference signal (Ur1) is passed via a further conductor track (R2) or a part thereof, which conductor track (R2) is in thermal contact with the first conductor track (R3).

10. Overload protection circuit according to Claim 9, characterized in that the first and the further conductor track (R3, R2) or their corresponding parts are components of a printed circuit, and in that the conductor tracks (R3, R2) and/or their parts are arranged in an adjacent manner on the circuit carrier.

11. Overload protection circuit according to one of Claims 7 to 10, characterized in that an inductance (L1) is provided between the control element (F1) and the current sensor (R3) in order to evaluate the current via the control element (F1), and in that the error amplifier (FV) is additionally fed with a signal which can be picked off between the control element (F1) and the inductance (L1).

## Revendications

1. Circuit de protection contre les surcharges d'un organe de réglage (F1) d'un régulateur utilisant un comparateur (KO) comparant une grandeur électrique (UD) appliquée à l'organe de réglage (F1), à un signal de référence (Ur1), et coupant l'organe de réglage (F1) lorsqu'on atteint une perte d'énergie prédéterminée, le comparateur (KO) étant précédé d'un intégrateur (R1, C1),
caractérisé en ce que
l'intégrateur (R1, C1) est branché pour intégrer la tension de l'organe de réglage et sa constante de temps est choisie en fonction de la constante de temps thermique de l'organe de réglage (F1) pour que la tension de l'intégrateur (R1, C1) soit une mesure de l'énergie perdue ou de la température de l'organe de réglage (F1).

2. Circuit de protection contre les surcharges selon la revendication 1,
caractérisé par
des moyens (F2, F3, F4) destinés à court-circuiter l'organe de réglage (F1) du régulateur notamment en dehors de son mode de fonctionnement en régulateur, à l'état complètement passant, par un chemin faiblement ohmique.

3. Circuit de protection contre les surcharges selon la revendication 1 ou 2,
caractérisé en ce que
l'intégrateur se compose d'un élément RC (R1, C1) et son installation d'exploitation (K1, K2) détermine si le régulateur est en dehors de son mode de régulation, cette installation d'exploitation assurant la décharge du condensateur (C1) de l'élément RC (R1, C1) pour ce mode de fonctionnement.

4. Circuit de protection contre les surcharges selon l'une des revendications 1 à 3,
caractérisé en ce que
l'organe de réglage (F1) est un transistor à effet de champ et la constante thermique de l'organe de réglage (F1) est définie suivant la constante de temps de l'élément intégrateur RC (R1, C1) pour que la tension aux bornes du condensateur intégrateur (C1) soit une mesure de la température de la couche de blocage du transistor à effet de champ (F1).

5. Circuit de protection contre les surcharges selon l'une des revendications 1 à 4,
caractérisé par
une installation de remise à l'état initial (RS) pour décharger rapidement le condensateur intégrateur (C1) et le cas échéant éviter une mise en oeuvre non protégée de l'organe de réglage (F1).

6. Circuit de protection contre les surcharges selon l'une des revendications 1 à 5,
caractérisé en ce que
les moyens pour court-circuiter d'une manière faiblement ohmique l'organe de réglage (F1) se composent d'un ou plusieurs transistors à effet de champ (F2, F3, F4) branchés en parallèle et qui peuvent être coupés par l'installation d'exploitation (K1, K2) lorsque le courant dans l'organe de réglage (F1) dépasse une valeur prédéterminée.

7. Circuit de protection contre les surcharges selon l'une des revendications 1 à 6,
caractérisé par
un amplificateur d'erreur (FV) pour commander l'organe de réglage (F1), cet amplificateur comparant un signal proportionnel à l'intensité dans l'organe de réglage (F1), à un signal de référence (Ur1) modifié en fonction du signal de sortie du comparateur (KO).

8. Circuit de protection contre les surcharges selon la revendication 7,
caractérisé en ce que
l'amplificateur d'erreur (FV) comporte un couplage en réaction constitué seulement par une diode Zener (ZD1).

9. Circuit de protection contre les surcharges selon les revendications 7 ou 8,
caractérisé en ce que
un capteur d'intensité (R3) est associé à l'amplificateur d'erreur (FV) pour exploiter l'intensité traversant l'organe de réglage (F1), ce capteur se composant d'un premier chemin conducteur ou d'une partie d'un tel chemin, et le signal de référence (Ur1) passant par un autre chemin conducteur (R2) ou une partie d'un tel chemin en contact thermique avec le premier chemin conducteur (R3).

10. Circuit de protection contre les surcharges selon la revendication 9,
caractérisé en ce que
le premier et les autres chemins conducteurs (R3, R2) ou des parties de ceux-ci appartiennent à un circuit imprimé, les chemins conducteurs (R3, R2) ou les parties de ceux-ci étant voisins sur le support du circuit imprimé.

11. Circuit de protection contre les surcharges selon l'une des revendications 7 à 10,
caractérisé en ce que
une inductance (L1) est prévue entre l'organe de réglage (F1) et le capteur de courant (R3) pour exploiter l'intensité du courant passant par l'organe de réglage (F1), et l'amplificateur d'erreur (FV) reçoit en outre un signal pris entre l'organe de réglage (F1) et l'inductance (L1).
